(19) Europäisches Patentamt

European Patent Office

Office européen des brevets

(11) **EP 0 814 482 B1**

(12) **EUROPEAN PATENT SPECIFICATION**

(45) Date of publication and mention
of the grant of the patent:
**27.08.2003 Bulletin 2003/35**

(51) Int Cl.⁷: **G11C 16/06**

(21) Application number: **96830346.1**

(22) Date of filing: **18.06.1996**

(54) **Method and circuit for generating a read reference signal for nonvolatile memory cells**

Verfahren und Schaltung zum Erzeugen eines Lesereferenzsignals für nichtflüchtige Speicherzellen

Procédé et circuit de génération de signal de référence de lecture pour cellules de mémoire non-volatiles

(84) Designated Contracting States:
**DE FR GB IT**

(43) Date of publication of application:
**29.12.1997 Bulletin 1997/52**

(73) Proprietor: **STMicroelectronics S.r.l.**
**20041 Agrate Brianza (Milano) (IT)**

(72) Inventors:
• **Campardo, Giovanni**
**24128 Bergamo (IT)**

• **Micheloni, Rino**
**22078 Turate (IT)**
• **Maccarrone, Marco**
**27030 Palestro (IT)**

(74) Representative: **Cerbaro, Elena, Dr. et al**
**STUDIO TORTA S.r.l.,**
**Via Viotti, 9**
**10121 Torino (IT)**

(56) References cited:
**EP-A- 0 326 004**      **EP-A- 0 676 768**
**US-A- 5 386 388**

EP 0 814 482 B1

**Description**

The present invention relates to a method and circuit for generating a read reference signal for a nonvolatile memory.

As is known, to read the cells of nonvolatile, particularly flash, memories, the row and column to which the cell to be read is connected are appropriately biased and the current flow through the cell is detected. If the cell is written, its threshold voltage is higher than the read voltage and the cell conducts no current; if the cell is erased, its threshold voltage is lower than the read voltage, and the cell conducts current; and written and erased cells are discriminated by comparing the current flow in the cell with a reference current generated by a reference cell. The comparison is made by a read circuit comprising a current/voltage converter for converting the current of the cell to be read and the reference cell into corresponding voltages; and a sense amplifier for comparing the two voltages and generating a logic output signal, the state of which depends on the outcome of the comparison.

To ensure correct read operation and reliable cycling (multiple cycle operation) of the memory array, certain limits must be posed to the distribution of the threshold voltages of the cells. More specifically, currently used technologies require that the threshold voltage of the most erased cells be above zero, and the threshold voltage of the worst erased cells be about 2.5 V. The lower limit substantially arises from the need to ensure against read errors caused by depleted cells (cells with a threshold voltage below zero); while the upper limit is due to the intrinsic distribution of the cell threshold voltages according to the fabrication technology used.

Since the read voltage normally coincides with the supply voltage, read problems arise in the case of a low supply voltage (about 2.5 V), due to the poorly erased cells, which conduct a very low current, being considered written and so resulting in read errors.

In view of the current demand for memories capable of operating within a wide range in relation to the supply voltage (typically, with supply voltages of 2.5 to 4 V) and with fast access times (<100 ns), a sense amplifier is required, which is capable of fast, correct reading within the full range of supply voltages involved.

To solve the problem of achieving a reasonable read time of poorly erased cells, a co-pending patent application (EP 0 814 480 A), entitled "Method and circuit for reading low-supply-voltage memory array cells", filed concurrently by the present Applicant, relates to a solution in which the current/voltage converter operates in the opposite way as compared with standard converters, to enable even poorly erased array cells to be read rapidly in the presence of low supply voltage (when the memory cells conduct a low current).

For the written cells to be determined correctly, however, the above solution poses limits as regards the maximum permissible supply voltage.

To give a clearer idea of the problem, Figures 1 and 2 show the solution proposed in the above co-pending patent application.

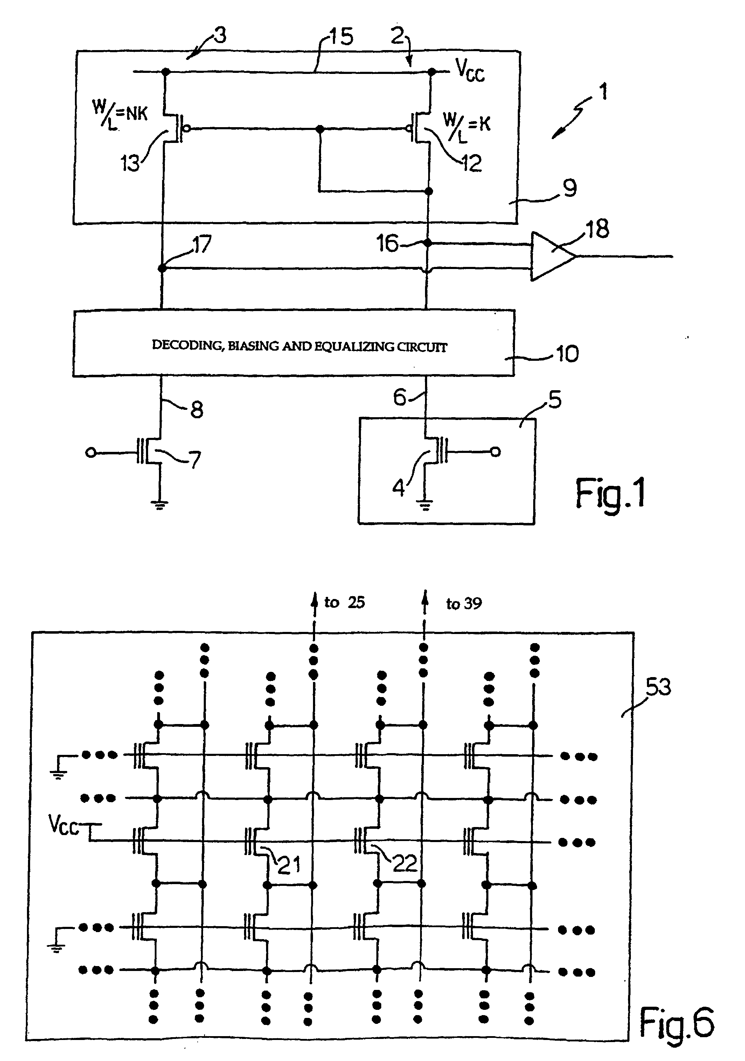

In Figure 1, the read circuit is indicated by 1, and comprises an array branch 2 and a reference branch 3; array branch 2 comprises an array cell 4 to be read, forming part of a memory array 5 and connected to an array bit line 6; reference branch 3 comprises a reference cell 7 connected to a reference bit line 8; array bit line 6 (together with other array bit lines not shown and forming part of memory array 5) and reference bit line 8 are connected to a current/voltage converter 9 via a known decoding, biasing and equalizing circuit 10 not essential to the description and therefore not shown in detail; and circuit 10 provides for selecting the array bit line 6 of the cell 4 to be read, appropriately biasing it (and reference bit line 8) to prevent spurious read phenomena such as soft writing, and possibly also equalizing lines 6 and 8 before the cell is actually read.

Converter 9 comprises an array load 12 and reference load 13 forming a current mirror circuit and connected to array and reference bit lines 6 and 8 via circuit 10. More specifically, and according to the teachings of the above co-pending patent application, array load 12 comprises a diode-connected PMOS transistor, and reference load 13 a PMOS transistor; array load transistor 12 has the source terminal connected to a supply line 15 at $V_{CC}$, the drain terminal connected to circuit 10 at a node 16, the gate terminal connected to the gate terminal of reference load transistor 13, and a width/length ratio W/L = K; and reference load transistor 13 has the source terminal connected to supply line 15, the drain terminal connected to circuit 10 at a node 17, and a width/length ratio W/L = N*K, where N is a multiplication constant.

Nodes 16, 17 are connected to the inputs of sense amplifier 18.

In the Figure 1 circuit, since the diode (low-impedance) element is connected to array bit line 6 instead of to reference bit line 8, and in view of the width/length ratio of transistors 12 and 13, the current in I/V converter 9 is imposed by memory cell 4, and is supplied, amplified by N, to reference branch 3 where it is compared with the current flowing in reference cell 7. This therefore provides for rapidly reading the array cell, even when it is poorly erased and conducts only a small amount of current due to the low supply voltage.

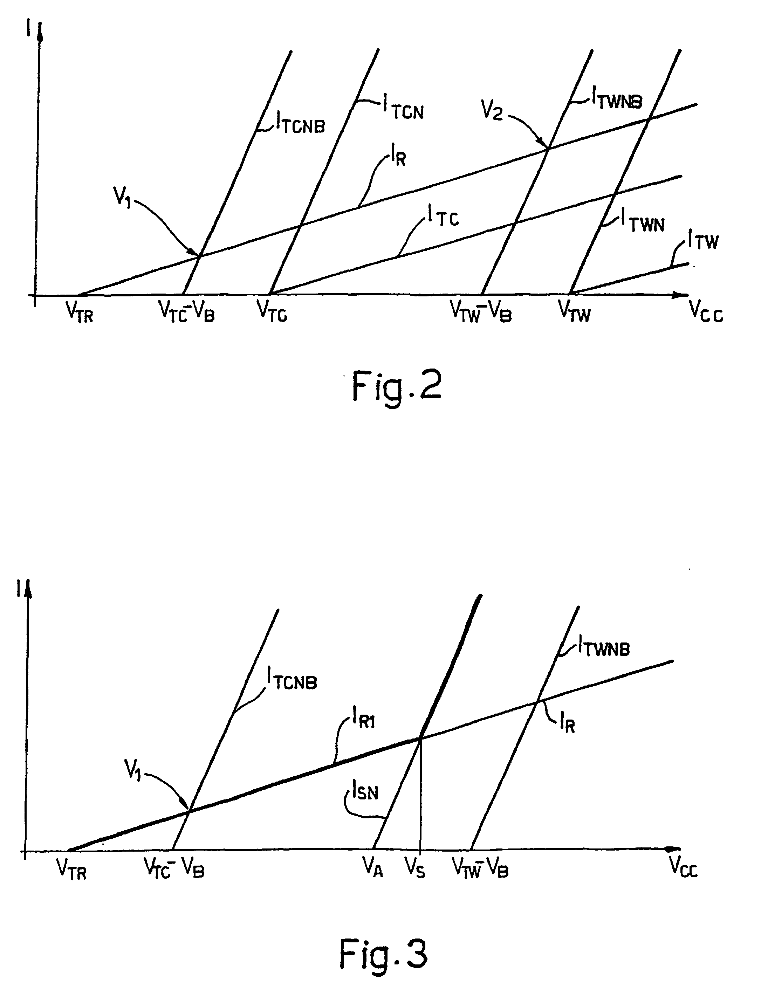

Figure 2 shows the current/voltage characteristics obtainable from the Figure 1 circuit by biasing the drain terminal of the cells (both array and reference cells) at about 1 V (linear operating region) and assuming a boost voltage $V_B$ is used to increase the voltage $V_{GS}$ between the gate and source terminals of cell 4 in respect to supply voltage $V_{CC}$.

In Figure 2, $I_R$ indicates the I/V characteristic of the reference cell with a fixed, known threshold voltage $V_{TR}$; $I_{TC}$ indicates the characteristic of the worst erased array cell with the maximum permissible threshold voltage $V_{TC}$ (2.5 V with the above specifications); $I_{TCN}$ indicates characteristic $I_{TC}$ amplified by the Figure 1 configuration; $I_{TCNB}$ indicates characteristic $I_{TCN}$ in the presence of bootstrap voltage $V_B$ - by which it is shifted by $V_B$ towards the origin - and therefore presenting a threshold voltage of $(V_{TC} - V_B)$; $I_{TW}$ indicates the characteristic of the worst written array cell with the minimum permissible threshold voltage $V_{TW}$; $I_{TWN}$ indicates characteristic $I_{TW}$ amplified by the Figure 1 configuration; and $I_{TWNB}$ indicates characteristic $I_{TWN}$ in the presence of bootstrap voltage and with a threshold voltage of $(V_{TW} - V_B)$.

As shown clearly in Figure 2, the intersection of characteristics $I_R$ and $I_{TCNB}$ determines the minimum supply voltage $V_1$, and that of characteristics $I_R$ and $I_{TWNB}$ the maximum supply voltage $V_2$, i.e. the voltages below and above which reading (recognition of erased and written cells respectively) is not possible.

Voltages $V_1$ and $V_2$ may be determined analytically, bearing in mind that:

$$I_R = G*(V-V_{TR}) \quad (1)$$

$$I_{TC} = G*(V-V_{TC})$$

$$I_{TCN} = N*I_{TC} = N*G*(V-V_{TC})$$

$$I_{TW} = G*(V-V_{TW})$$

$$I_{TWN} = N*I_{TW} = N*G*(V-V_{TW})$$

$$I_{TCNB} = N*G*(V-V_{TC}+V_B) \quad (2)$$

$$I_{TWNB} = N*G*(V-V_{TW}+V_B) \quad (3)$$

where G is the slope of the nonamplified characteristics.

By equaling relation (1) to (2) and relation (1) to (3), the following voltages are obtained:

$$V_1 = (N*V_{TC}-N*V_B-V_{TR})/(N-1)$$

$$V_2 = (N*V_{TW}-N*V_B-V_{TR})/(N-1)$$

For example, if $V_{TC}$ = 2.5 V, $V_{TW}$ = 4.5 V, $V_{TR}$ = 1.25 V, $V_B$ = 0.8 V and N = 8, then $V_1$ = 1.76 V and $V_2$ = 4 V.

As such, though the above solution provides for reading memory cells even when the minimum supply voltage is low, the maximum permissible supply voltage is also low.

EP-A-0 676 768 discloses a nonvolatile memory device operating both at low and at high supply voltages wherein the current versus supply voltage reference characteristic curve is split into two portions, the first portion having a slope equal to a fraction of that on an array cell, and the second portion having a slope equal to that of the array cell.

It is an object of the present invention to provide a method and circuit for also reading memory cells with a high maximum supply voltage, but without at the same time increasing the minimum supply voltage.

According to the present invention, there are provided a method and circuit for generating a reference signal for reading a nonvolatile memory, as claimed respectively in Claims 1 and 5.

A preferred, non-limiting embodiment of the present invention will be described by way of example with reference to the accompanying drawings, in which:

Figure 1 shows an electric diagram of a read circuit as described in the aforementioned co-pending patent application;
Figure 2 shows the characteristics obtainable from the Figure 1 circuit;
Figure 3 shows the characteristics obtainable from the method according to the present invention;
Figures 4a, 4b and 4c show how to obtain the reference characteristic in Figure 3;
Figure 5 shows an electric diagram of the circuit for generating the reference characteristic in Figure 3;
Figure 6 shows an equivalent diagram of a variation of a detail in Figure 5;
Figure 7 shows an electric diagram of an equalizing circuit as applied to the Figure 1 circuit;
Figure 8 shows an electric diagram of a new equalizing circuit;
Figure 9 shows a graph of a number of electric quantities in the Figure 7 and 8 diagrams.

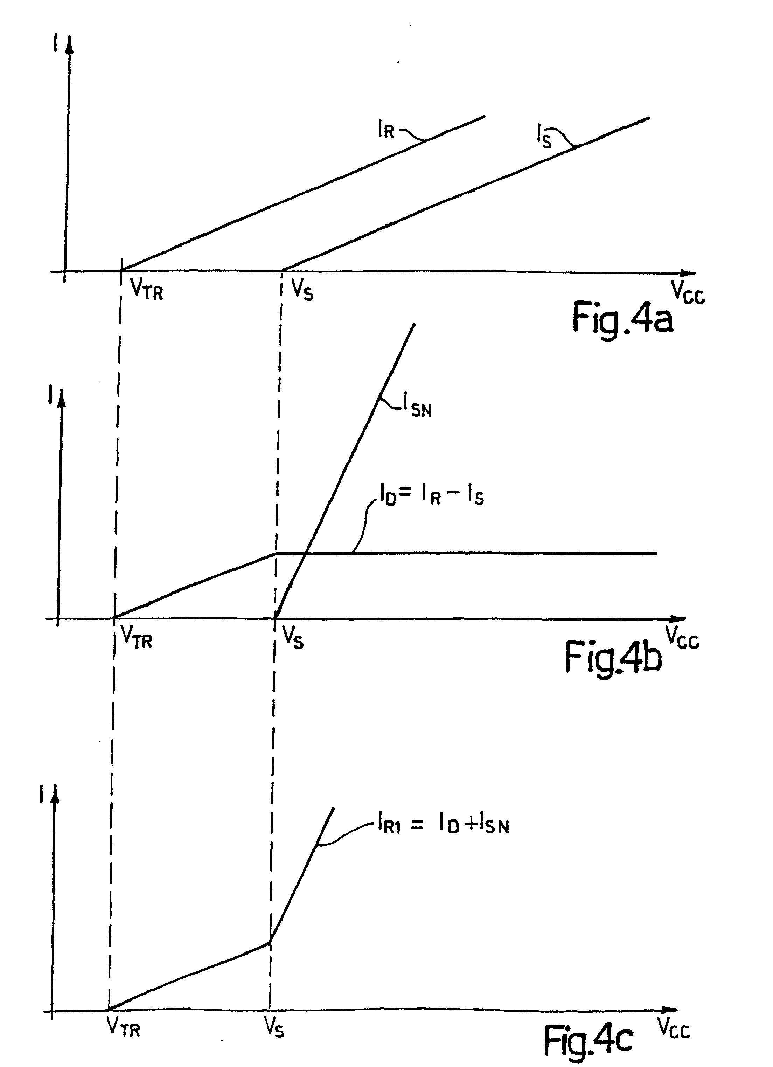

In Figure 3, characteristics $I_{TCNB}$, $I_{TWNB}$, $I_R$ and threshold voltages $V_{TR}$, $(V_{TC} - V_B)$, $(V_{TW} - V_B)$ have the same meaning as in Figure 2, whereas the reference characteristic is indicated $I_{R1}$. As can be seen, the reference characteristic, generated by the reference branch of the array, comprises two segments: a first segment coinciding with the first portion of characteristic $I_R$ in Figure 2 up to a trigger voltage $V_S$; and a second segment coinciding with a characteristic $I_{SN}$ presenting a threshold voltage $V_A$ between $(V_{TC} - V_B)$ and $(V_{TW} - V_B)$ and a slope N*G.

The fact that the first part of characteristic $I_{R1}$ coincides with $I_R$ permits the same minimum value $V_1$ of supply voltage $V_{CC}$ to be maintained, while at the same time ensuring a high current difference between the array and reference branches and enhancing dynamic performance.

The second segment with a steeper slope parallel to that of the amplified array characteristic, on the other hand, provides for eliminating the maximum limit posed on the supply voltage.

In selecting value $V_S$ marking the change in the slope of characteristic $I_{R1}$, a trade-off must be made between the minimum permissible threshold value for the written cells and the current value required at low supply voltage to conform with the specified access time (since a low supply voltage corresponds with a low current value and hence slow charging and discharging of capacitive nodes). With the threshold voltages indicated above, for example, a $V_S$ value of 3 V may be selected.

Characteristic $I_{R1}$ may be obtained as shown in Figures 4a, 4b and 4c from characteristic $I_R$ with threshold voltage $V_{TR}$ and from characteristic $I_S$ with threshold voltage $V_S$ and the same slope as characteristic $I_R$; and characteristic $I_S$ may be obtained either by appropriately regulating the threshold voltage of a special reference cell appropriately located in the memory device (outside array 5), or by adding two thresholds as explained in detail later on.

To obtain characteristic $I_{R1}$, first of all a difference characteristic $I_D = I_R - I_S$ equal to the difference between characteristics $I_S$ and $I_R$ is obtained; a characteristic $I_{SN}$ (Figure 4b) is obtained by amplifying characteristic $I_S$ with a current mirror similar to that forming I/V converter 9; and, finally, characteristics $I_D$ and $I_{SN}$ are added to give characteristic $I_{R1}$ as shown in Figure 4c.

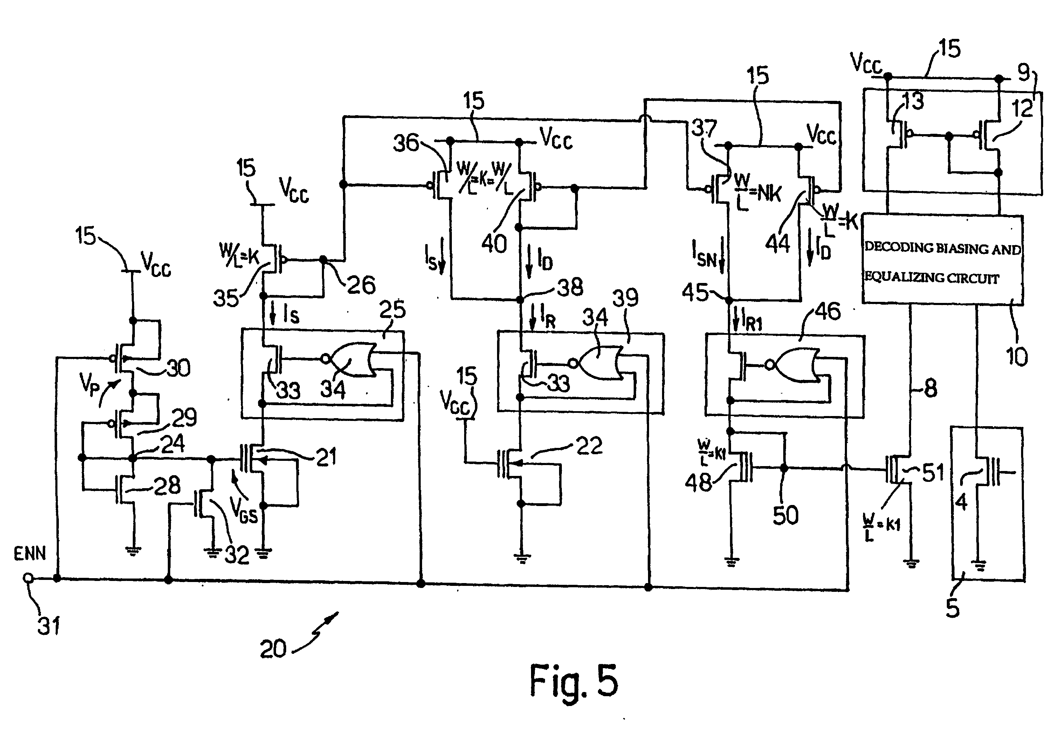

A generating circuit capable of generating the above characteristic $I_{R1}$ is shown in Figure 5 and described below.

The generating circuit, indicated by 20 in Figure 5, comprises two floating-gate type (e.g. flash) memory cells 21, 22, both with threshold voltage $V_{TR}$. More specifically, cell 21 has the source terminal and bulk region grounded, the gate terminal connected to a node 24, and the drain terminal connected to a node 26 via a protection circuit 25 (to prevent phenomena such as soft writing); node 24 is grounded via a diode-connected NMOS transistor 28 (drain and gate terminals shorted and connected to node 24) and is connected to supply line 15 via two PMOS transistors 29, 30; transistor 29 is also diode-connected (drain and gate terminals shorted and connected to node 24); transistor 30 has the source terminal and bulk region connected to supply line 15, and the gate terminal connected to an input 31 supplied with an active-when-low inverted enabling signal ENN; and an NMOS transistor 32 has the drain terminal connected to node 24, the source terminal grounded, and the gate terminal connected to input 31 to ground node 24 in standby mode and so avoid consumption.

Protection circuit 25 comprises an NMOS transistor 33 interposed between the drain terminal of cell 21 and node 26; and a NOR gate 34 having a first input connected to the drain terminal of cell 21, a second input connected to input 31, and the output connected to the gate terminal of transistor 33, so that, when signal ENN is low, NOR gate 34 controls the power-on level of transistor 33 in known manner, and (by means of a negative feedback) maintains the drain terminal of cell 21 at the desired biasing voltage (typically 1 V). Conversely, when high, signal ENN forces the output of NOR gate 34 to switch to low, thus turning off transistor 33 and cutting off the connection between node 26 and cell 21.

A diode-connected PMOS load transistor 35 has the source terminal connected to supply line 15, the gate and drain terminals connected to node 26, and a width/length ratio W/L = K, and is so connected as to form a current mirror with a PMOS load transistor 36 and with a PMOS transistor 37; transistor 36 has the source terminal connected to supply line 15, the gate terminal connected to node 26, the drain terminal connected to a node 38, and a width/length ratio W/L = K equal to that of load transistor 35; and, via a protection circuit 39 identical to circuit 25 and therefore not described in detail, node 38 is connected to the drain terminal of cell 22, which has the gate terminal connected to supply line 15, and the source terminal and bulk region grounded.

Node 38 is also connected to the drain terminal of a diode-connected PMOS transistor 40, which has the gate terminal also connected to node 38, the source terminal connected to supply line 15, a width/length ratio W/L = K equal to that of load transistors 35 and 36, and forms a current mirror circuit with a PMOS transistor 44 also presenting a width/length ratio W/L = K.

Transistors 37 and 44, the gate terminals of which are connected respectively to nodes 26 and 38, have the source terminals connected to supply line 15, and the drain terminals connected to a node 45; transistor 37 presents a width/length ratio W/L = N*K N times greater than that of transistor 35 with which it is connected to form a current mirror; transistor 44 presents a width/length ratio W/L = K equal to that of transistor 40 with which it is connected to form a current mirror; and, via a protection circuit 46 identical to circuit 25 and therefore not described in detail, node 45 is connected to the drain terminal of a diode-connected native NMOS transistor 48 (i.e. with a low threshold voltage unaltered during fabrication). More specifically, native transistor 48 has the source terminal grounded, and the gate terminal forming a node 50 and connected to the drain terminal.

Transistor 48 forms a 1:1 current mirror circuit with one or more native NMOS transistors (one indicated by 51 in Figure 5) connected to reference bit lines 8 of the various read circuits of the memory; and K1 in Figure 5 indicates the width/length ratio of transistors 48 and 51, which is identical for both. For a clearer understanding of the connection of generating circuit 20 to read circuit 1, Figure 5 also shows current/voltage converter 9, decoding, biasing and equalizing circuit 10, and memory cell 4 of Figure 1.

The Figure 5 circuit operates as follows.

When signal ENN is low (circuit 20 enabled), transistor 30 is turned on and connects diode-connected transistor 29 to supply line 15; transistor 32 is turned off; and the outputs of the NOR gates of protection circuits 25, 39 and 44 are not forced to zero, so that the voltage at node 24 is somewhere between supply voltage $V_{CC}$ and ground, depending on the sizing of diode-connected transistors 28, 29. More specifically, if $V_P$ is the threshold voltage of diode-connected transistor 29, equal to the minimum source-gate voltage drop for transistor 29 to be turned on, and by so sizing transistors 28, 29 that transistor 28 is much more resistive than transistor 29 and, hence, the difference between supply voltage $V_{CC}$ and threshold voltage $V_P$ of transistor 29 falls entirely on diode-connected transistor 28, then cell 21 has a gate-source voltage drop $V_{GS}$ of $V_{CC}$ - $V_P$. In which case, and bearing in mind that cell 21 presents a threshold voltage of $V_{TR}$, cell 21 remains off as long as supply voltage $V_{CC}$ is less than the sum of threshold voltage $V_{TR}$ of cell 21 and voltage drop $V_P$. Above this supply voltage value, cell 21 starts conducting current, controlled by voltage $V_{GS}$, and therefore functions as a cell with a threshold voltage $V_S$ of $V_{TR}$ + $V_P$.

From the above, it is clear that the current controlled by cell 21 and flowing in load transistor 35 equals current $I_S$ in Figure 4a. Since transistor 36 forms a 1:1 mirror with transistor 35, the current flowing through transistor 36 is equal to $I_S$; the current in transistor 37 equals $N*I_S$, due to the width/length ratio of transistor 37 being N times greater than that of load transistor 35, and therefore corresponds to current $I_{SN}$ in Figure 4b. Due to the gate terminal of cell 22 being connected directly to the supply line, the current flowing in cell 22 equals $I_R$, so that the current flowing in transistor 40, equal to the difference between current $I_R$ imposed by cell 22 and current $I_S$ supplied by transistor 36, equals current $I_D$ in Figure 4b; current $I_D$ is mirrored by transistor 44 and supplied to node 45 together with current $I_{SN}$ supplied by transistor 37; and native transistor 48 therefore receives and transfers current $I_{R1}$ in Figure 4c to reference bit line 5 via transistor(s) 51.

Current $I_{R1}$ so generated may therefore be transferred easily to the rest of the memory device using only one reference circuit 20 for all the device outputs.

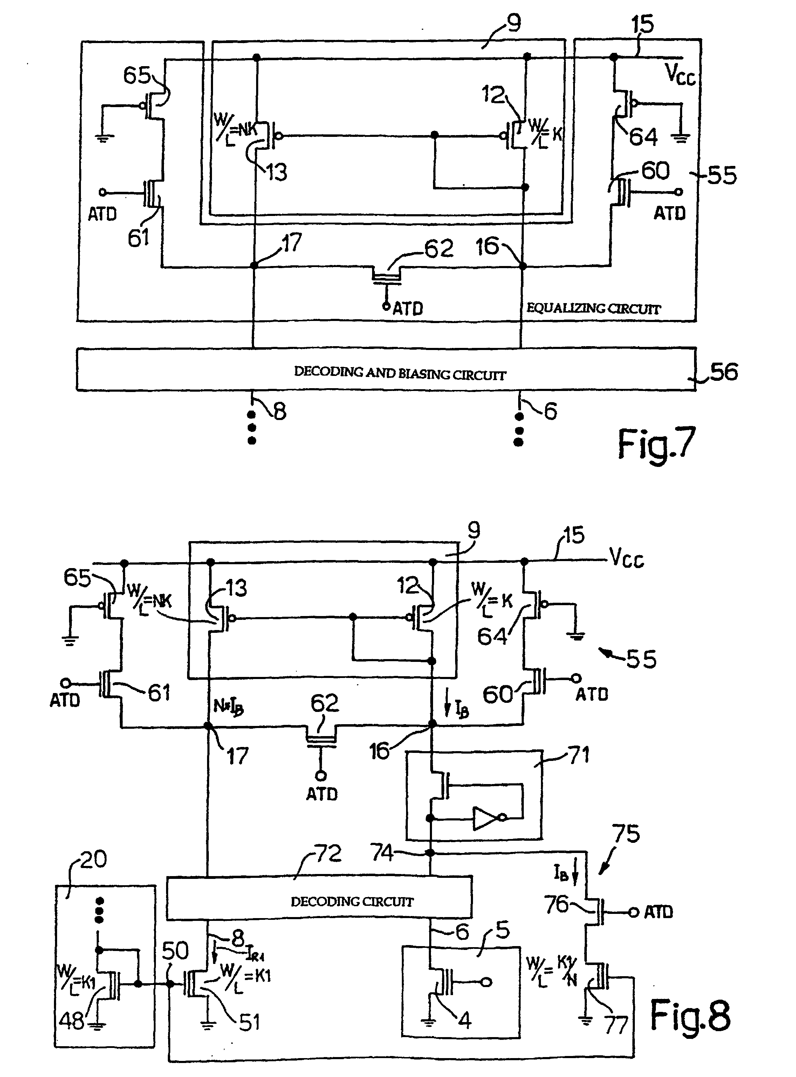

As an alternative to the Figure 5 arrangement, memory cells 21 and 22 may be located outside memory array 5. More specifically, in the Figure 6 example, a small, e.g. 8x8, cell array 53 is formed, and cells 21, 22 are selected from among the innermost cells to reduce the edge effects, and may therefore be written or erased in known manner during final EWS (Electrical Wafer Sort) testing of the device.

Being able to adjust the threshold voltage of cells 21, 22 in an independent way to the most appropriate value, the gate terminal of cell 21 may be connected directly to the supply line like cell 22, thus eliminating transistors 28-30 and directly setting the threshold voltage of cell 21 to the desired $V_S$ value. The advantage of this solution lies in the threshold voltage of characteristic $I_S$ (which, as is known, varies with temperature) depending solely on the variations of one component (cell 21 itself) instead of on those of two components (cell 21 and transistor 29 in the Figure 5 embodiment), so that the temperature performance of current $I_S$ is substantially the same as that of the other quantities generated by the other components of the device (cell 22 included). Moreover, the above solution also provides for using only two reference cells for the whole memory device.

Circuit 20 therefore permits read circuit 1 in Figure 1 to be operated at both low and high supply voltage $V_{CC}$ (the maximum supply voltage is theoretically infinite) without penalizing either limit. Moreover, it is simple, reliable, and presents zero consumption in standby mode.

When read circuit 1 operates at low supply voltage, current flow in the circuit is low, but, on the other hand, the time taken to charge and discharge the capacitive nodes is increased, thus slowing down the read operation. One known solution to speed up reading of the cell is to use an equalizing network to connect nodes 16 and 17 and bring them to the same voltage at the ATD (Address Transition Detection) step, in which the addresses of the memory cells switch (high ATD pulse signal) before they are read.

More specifically, in Figure 7, circuit 10 in Figure 1 is shown divided into a known equalizing circuit 55 and a known decoding and biasing circuit 56 (not shown in detail). Equalizing circuit 55 substantially comprises a pair of transistors 60, 61 connected between supply line 15 and respective nodes 16, 17; and a connecting transistor 62 connected between nodes 16 and 17. More specifically, transistors 60-62 are native (low-threshold) NMOS transistors; PMOS protection transistors 64 and 65 are located between supply line 15 and respective transistors 60 and 61; and both transistors 64, 65 have the gate terminals grounded so that they are always turned on, and provide for protecting respective native transistors 60, 61 from voltage peaks on supply line 15.

The gate terminals of transistors 60, 61, 62 are all supplied with signal ATD so that, in the time interval in which signal ATD is high, they are turned on and bring nodes 16 and 17 to a voltage substantially equal to the high voltage of signal ATD (e.g. 3 V) less a threshold voltage (voltage drop $V_{GS}$ between the gate and source terminals). At the end of the ATD pulse, therefore, nodes 16 and 17 are at the same voltage, so that they are brought more rapidly to the voltage compatible with the erased or written state of the array cell to be read.

The actual (equalizing) voltage reached by nodes 16 and 17 at the equalizing step, however, depends on various parameters, such as temperature and current flow in the two branches, and, there being no possibility of establishing it accurately beforehand, may be too low or too high, thus impairing the effect of the equalizing function on read time.

If the equalizing voltage is too high (high voltage at nodes 16, 17), erased cell reading is slow. More specifically, with too high an equalizing voltage, load transistors 12, 13 forming I/V converter 9 may be turned off (insufficient source-gate voltage drop), so that, when equalizing transistors 60-62 are turned off at the end of the equalizing step, there is no current flow in load transistor 13 (which is still turned off), whereas reference cell 7 is turned on and drawing current. As such, nodes 16 and 17 function as if the array cell 4 to be read were written, even when in actual fact it is erased, so that, when reading an erased cell, the sense amplifier first supplies a wrong reading, which, though later corrected when converter 9 is turned on, results in a certain loss of time and hence an increase in read time.

Conversely, if the set equalizing voltage is too low, nodes 16 and 17 are brought to too low a voltage, so that written cell reading is slow. That is, the control voltage (source-gate voltage drop) of load transistors 12, 13 is so high as to bring nodes 16 and 17 to a voltage corresponding to an erased cell 4, even when in actual fact it is written. In the case of a written memory cell 4, a wrong initial setting of this sort is further compounded initially by the parasitic capacitances associated with bit line 6 (which must rise from the previous excessively low voltage to the correct level) absorbing current, which, albeit small, is amplified by converter 9 and interpreted at node 17 as being due to an erased cell. In the case of a written cell and too low an equalizing voltage, before the circuit reaches the correct condition, the above two effects combined cause the sense amplifier to supply a reading corresponding to an erased cell 4 and which, though corrected later, also means the correct reading is only obtained some time after the end of the ATD pulse.

For solving this problem, provision is made for an adaptive equalizing network for automatically setting the equalizing voltage of nodes 16 and 17 at an intermediate point corresponding to a balanced condition of the array and reference branches, i.e. the current required by reference bit line 8 equals the current supplied by I/V converter 9. The above condition is balanced in the sense that it is exactly halfway between the written cell read condition (current demand by reference branch 3 greater than that - ideally zero - supplied by array branch 2 via load 13) and the erased cell read condition (current supply by load 13 greater than the current demand of reference branch 3), so that the circuit is in an excellent condition to be unbalanced one way or the other at the end of the ATD pulse, depending on the state of array cell 4.

To achieve the above balanced condition, despite the unbalance due to the difference in the sizing of load transistors 12 and 13, provision is made, as shown in Figure 8, for a grounding current path connected to the array branch, which is active at the equalizing step and provides for the same but opposite current unbalance as that produced by I/V converter 9. More specifically, in Figure 8, circuit 10 in Figure 1 is shown divided into its three components: known equalizing circuit 55; biasing circuit 71 (similar to circuits 25, 39, 46 in Figure 5) for preventing soft writing; and decoding circuit 72. A node 74 is provided between biasing circuit 71 and decoding circuit 72; a balancing branch 75 is provided between node 74 and ground to define a grounding path, and comprises an NMOS selection transistor 76 and a native NMOS balancing transistor 77; selection transistor 76 has the drain terminal connected to node 74, the gate terminal supplied with signal ATD, and the source terminal connected to the drain terminal of balancing transistor 77; and balancing transistor 77 has the source terminal grounded, and the gate terminal connected to node 50 of generating circuit 20 in Figure 5. In practice, like transistor 51 connected to reference bit line 8, balancing transistor 77 is connected to form a current mirror with transistor 48 of circuit 20, but presents a width/length ratio N times smaller than transistor 51, i.e. equal to K1/N.

At the equalizing step, when signal ATD is high and equalizing network 55 is active, balancing branch 75 is therefore also active, and balancing transistor 77 draws a current $I_B$ N times smaller than current $I_{R1}$ drawn by transistor 51; current $I_B$, supplied by load transistor 12 of I/V converter 9, is mirrored, multiplied N times, by load transistor 13, so that it equals current $I_{R1}$ drawn by transistor 51; the read circuit is therefore balanced, with nodes 16 and 17 at a voltage halfway between those corresponding to a written and erased cell, so that the load transistors are neither turned on nor off excessively; thus, when, at the end of the ATD pulse, transistors 60, 61, 62 and 76 are turned off (disabling equalizing network 55 and balancing branch 75), the read circuit is ready to detect the actual state of cell 4 to be read, with none of the delays due to spurious initial switching, as described above.

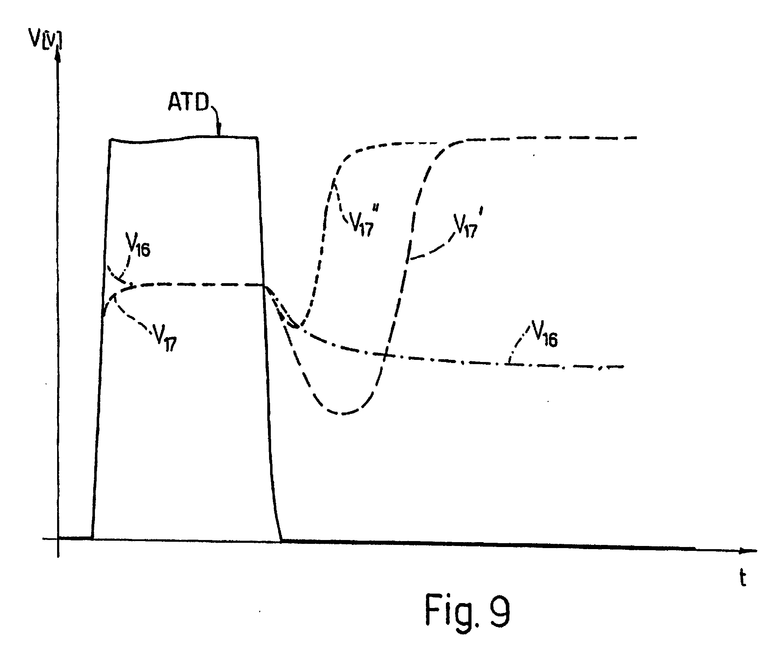

To show the read speed obtainable by virtue of balancing branch 75, Figure 9 shows the difference in the voltage behavior at reference node 17 using the Figure 7 and 8 circuits and relative to an erased array cell 4. In Figure 9, $V_{16}$ indicates the voltage at node 16; $V_{17}$ the voltage at node 17 in both the Figure 7 and 8 circuits; $V_{17}'$ the voltage at node 17 in the Figure 7 circuit; and $V_{17}''$ the voltage at node 17 in the Figure 8 circuit. As shown, in the presence of the ATD pulse, voltage $V_{17}$ equals $V_{16}$ in both circuits. At the end of the ATD pulse, on the other hand, voltage $V_{17}'$ in the Figure 7 circuit falls for a given time below $V_{16}$, thus causing a wrong initial reading, and requires additional read time to reach the correct (high) value; whereas voltage $V_{17}''$ in the Figure 8 circuit reaches the correct voltage much more quickly, thus supplying a correct reading immediately and so greatly reducing read time as compared with the Figure 7 circuit.

As such, low-voltage dynamic performance of the read circuit is enhanced and comparable with that obtainable at high voltage and hence high current.

Clearly, changes may be made to the method and circuit as described and illustrated herein without, however, departing from the scope of the present invention. In particular, circuit 20 may differ from that described, and any of the elements may be replaced by technical equivalents.

**Claims**

1.  A method of generating a read reference signal for a nonvolatile memory comprising memory cells (4) with a cell current ($I_{TC}$, $I_{TW}$) presenting a cell current versus supply voltage characteristic slope; **characterized by** the step of generating a reference current ($I_{R1}$) with a reference current versus supply voltage characteristic presenting a first portion extending between a predetermined threshold voltage value ($V_{TR}$) and a trigger voltage value ($V_S$) higher than said threshold voltage value ($V_{TR}$) and having a slope equal to said cell characteristic slope, and a second portion extending from said trigger value towards higher supply voltage values and having a slope steeper than said cell characteristic slope.

2.  A method as claimed in Claim 1, **characterized in that** said predetermined threshold value ($V_{TR}$) of said reference signal ($I_{R1}$) is less than a permissible maximum threshold value ($V_{TC}$) for an erased cell; and said trigger value ($V_S$) is between said permissible maximum threshold value for an erased cell and a permissible minimum threshold value ($V_{TW}$ - $V_B$) for a written cell.

3.  A method as claimed in Claim l or 2, **characterized in that** said step of generating a reference signal comprises the steps of:

    -   generating a first signal ($I_R$) having a threshold voltage equal to said predetermined threshold value ($V_{TR}$), and a slope equal to said cell characteristic slope;
    -   generating a second signal ($I_S$) having a threshold voltage equal to said trigger value ($V_S$), and a slope equal to said cell characteristic slope;
    -   generating a third signal ($I_D$) equal to the difference between said first and second signals;
    -   generating a fourth signal ($I_{SN}$) having a threshold voltage equal to said trigger value, and a slope steeper than said cell characteristic slope; and
    -   adding said third and fourth signals.

4.  A method as claimed in any one of the foregoing Claims, **characterized in that** said slope of said second portion of said reference characteristic ($I_{R1}$) equals a multiple of said cell characteristic slope.

5.  A memory device comprising non volatile memory cells(4) and a circuit for generating a read reference signal for said nonvolatile memory cells (4), said memory cells (4) having a cell current ($I_{TC}$, $I_{TW}$) presenting a cell current versus supply voltage characteristic slope; **characterized by** generating means (20) for generating a reference current ($I_{R1}$) with a reference current versus supply voltage characteristic comprising a first portion extending between a predetermined threshold voltage value ($V_{TR}$) and a trigger voltage value ($V_S$) higher than said threshold voltage value ($V_{TR}$) and having a slope equal to said cell characteristic slope, and a second portion extending from said trigger value towards higher supply voltage values and having a slope steeper than said cell characteristic slope.

6.  A circuit as claimed in Claim 5, **characterized in that** said generating means (20) comprise a first memory element (22) for generating a first signal ($I_R$) having a threshold voltage equal to said predetermined threshold value ($V_{TR}$) and a slope equal to said cell characteristic slope; a second memory element (21) for generating a second signal ($I_S$) having a threshold voltage equal to said trigger value ($V_S$) and a slope equal to said cell characteristic slope; a subtracting element (38) receiving said first and second signals to generate a third signal ($I_D$) equal to the difference between said first and second signals; a multiplying element (40, 44) receiving said second signal to generate a fourth signal ($I_{SN}$) having a threshold voltage equal to said trigger value and a slope steeper than said cell characteristic slope; and an adding element (45) receiving said third and fourth signals to generate said reference signal ($I_{R1}$).

7.  A circuit as claimed in Claim 6, **characterized in that** said first and second memory elements respectively comprise a first and a second memory cell (22, 21), each having a first terminal, a control terminal, and a threshold voltage equal to said predetermined threshold value ($V_{TR}$); said first memory cell (22) receiving a read biasing voltage ($V_{CC}$) between said first terminal and said control terminal; and said second memory cell (21) receiving, between said first terminal and said control terminal, a second biasing voltage ($V_{GS}$) lower than said read biasing voltage.

8.  A circuit as claimed in Claim 7, **characterized by** a read biasing line (15) connected directly to said control terminal of said first memory cell (22); and a shift transistor (29) interposed between said read biasing line (15) and said control terminal of said second memory cell (21).

9.  A circuit as claimed in Claim 6, **characterized in**

**that** said first and second memory elements respectively comprise a first and a second memory cell (22, 21), each having a first terminal and a control terminal; said first memory cell (22) having a threshold voltage equal to said predetermined threshold value ($V_{TR}$); said second memory cell (21) having a threshold voltage equal to said trigger value ($V_S$); and said first and second memory cells receiving an equal read biasing voltage ($V_{CC}$) between the respective first terminal and respective control terminal.

10. A circuit as claimed in Claim 9, **characterized by** a reference memory array (53); and in that said memory cells (22, 21) form part of said reference memory array.

11. A circuit as claimed in any one of the foregoing Claims from 5 to 10, **characterized by** a first current mirror circuit in turn comprising a first (35), a second (36) and a third (37) load transistor, said first load transistor (35) being diode-connected and interposed between said second memory element (21) and a reference potential line (15), said second load transistor (36) being interposed between said first memory element (22) and said reference potential line, said third load transistor (37) being interposed between an output element (48, 51) and said reference potential line, said first and second load transistors (35, 36) having a first dimensional ratio (W/L = K), and said third load transistor (37) having a second dimensional ratio (W/L = N*K) greater than said first dimensional ratio; and a second current mirror circuit in turn comprising a fourth (40) and a fifth (44) load transistor, said fourth load transistor (40) being diode-connected and interposed between said first memory element (22) and said reference potential line (15), said fifth load transistor (44) being interposed between said output element (48, 51) and said reference potential line, and said fourth and fifth load transistors (40, 44) having a third dimensional ratio (W/L = K).

12. A circuit as claimed in Claim 11, **characterized in that** said output element (48, 51) comprises a third current mirror circuit including a diode-connected first output transistor (48) connected to said third and fifth load transistors (37, 44), and at least a second output transistor (51) for connection to a reference branch (3) of a read circuit (1); said first and second output transistors having a fourth dimensional ratio (W/L = K1).

13. A circuit as claimed in Claim 12, **characterized in that** said first and second output transistors (48, 51) are native NMOS transistors.

**Patentansprüche**

1. Verfahren zum Erzeugen eines Lesereferenzsignals für einen nicht flüchtigen Speicher, welcher Speicherzellen (4) mit einem Zellstrom ($I_{TC}$, $I_{TW}$) aufweist, welcher eine Kennlinie Zell-Strom-gegen-Versorgungsspannung aufweist; gekenn zeichnet durch den Schritt des Erzeugens eines Referenzstromes ($I_{R1}$) mit einer Referenz-Strom-zu-Versorgungsspannung-Charakteristik, welche einen ersten Teil bietet, welcher sich zwischen einem vorher festgelegten Schwellspannungswert ($V_{TR}$) und einem Triggerspannungswert ($V_S$) höher als der Schwellspannungswert ($V_{TR}$) erstreckt und eine Steigung gleich der Zellcharakteristiksteigung besitzt, und einen zweiten Teil, welcher sich von dem Triggerwert in Richtung höherer Versorgungsspannungswerte erstreckt und eine Steigung steiler als die Zellcharakteristiksteigung aufweist.

2. Verfahren nach Anspruch 1, **dadurch gekennzeichnet, dass** der bestimmte Schwellwert ($V_{TR}$) des Referenzsignals ($I_{R1}$) kleiner ist als ein zulässiger maximaler Schwellwert ($V_{TC}$) für eine gelöschte Zelle; und der Triggerwert ($V_S$) zwischen dem zulässigen maximalen Schwellwert für eine gelöschte Zelle und einem zulässigen Minimalschwellwert ($V_{TW}$ - $V_B$) für eine beschriebene Zelle ist.

3. Verfahren nach Anspruch 1 oder 2, **dadurch gekennzeichnet, dass** der Schritt des Erzeugens eines Referenzsignals die Schritte aufweist:

   - Erzeugen eines ersten Signals ($I_R$), welches eine Schwellwertspannung gleich dem vorher festgelegten Schwellwert ($V_{TR}$) besitzt und eine Steigung gleich der Zellcharakteristiksteigung besitzt;
   - Erzeugen eines zweiten Signals ($I_S$), welches eine Schwellwertspannung gleich dem Triggerwert ($V_S$) und eine Steigung gleich der Zellcharakteristiksteigung besitzt;
   - Erzeugen eines dritten Signals ($I_D$) gleich der Differenz zwischen den ersten und zweiten Signalen;
   - Erzeugen eines vierten Signals ($I_{SN}$), welches eine Schwellwertspannung gleich zu dem Triggerwert und eine Steigung steiler als die Zellcharakteristiksteigung besitzt; und
   - Hinzufügen der dritten und vierten Signale.

4. Verfahren nach einem der vorausgehenden Ansprüche, **dadurch gekennzeichnet, dass** die Steigung des zweiten Teils der Referenzcharakteristik ($I_{R1}$) einem Vielfachen der Zellcharakteristiksteigung entspricht.

5. Speichervorrichtung, welche nicht flüchtige Speicherzellen (4) und eine Schaltung zum Erzeugen eines Lesereferenzsignals für die nicht flüchtigen Speicherzellen (4) besitzt, wobei die Speicherzellen (4) einen Zellstrom ($I_{TC}$, $I_{TW}$) besitzen, welcher eine Zellstrom-zu-Versorgungsspannung-Charakteristiksteigung darstellt; **gekennzeichnet durch**: Eine Erzeugungsvorrichtung (20) zum Erzeugen eines Referenzstroms ($I_{R1}$) mit einer Referenz-Strom-zu-Versorgungsspannung-Charakteristik, welche einen ersten Teil aufweist, welcher sich zwischen einem vorher festgelegten Schwellwertspannungswert ($V_{TR}$) und einem Triggerspannungswert ($V_S$) erstreckt, höher als der schwellwertspannungswert ($V_{TR}$), und welcher eine Steigung gleich der Zellcharakteristiksteigung besitzt und einen zweiten Teil aufweist, welcher sich von dem Triggerwert in Richtung höherer Versorgungsspannungswerte erstreckt und welcher eine Steigung steiler als die Zellcharakteristiksteigung besitzt.

6. Schaltung nach Anspruch 5, **dadurch gekennzeichnet, dass** die Erzeugungsvorrichtung (20) ein erstes Speicherelement (22) zum Erzeugen eines ersten Signals ($I_R$) aufweist, welches eine Schwellwertspannung gleich dem vorher festgelegten Schwellwert ($V_{TR}$) und eine Steigung gleich der Zellcharakteristiksteigung besitzt; dass ein zweites Speicherelement (21) zum Erzeugen eines zweiten Signals ($I_S$), welches eine Schwellwertspannung gleich dem Triggerwert ($V_S$) und eine Steigung gleich der Zellcharakteristiksteigung besitzt; das ein Subtrahierelement (38), welches die ersten und zweiten Signale empfängt, um ein drittes Signal ($I_D$) gleich der Differenz zwischen den ersten und zweiten Signalen zu erzeugen; das ein Multiplizierelement (40, 44) besitzt, welches das zweite Signal empfängt, um ein viertes Signal ($I_{SN}$) zu erzeugen, welches eine Schwellwertspannung gleich dem Triggerwert und eine Steigung steiler als der Zellcharakteristiksteigung besitzt; und ein Addierelement (45), welches die dritten und vierten Signale empfängt, um das Referenzsignal ($I_{R1}$) zu erzeugen.

7. Schaltung nach Anspruch 6, **dadurch gekennzeichnet, dass** die ersten und zweiten Speicherelemente jeweils eine erste und zweite Speicherzelle (22, 21) aufweisen, wobei jede einen ersten Anschluss, einen Steueranschluss und eine Schwellwertspannung gleich dem vorher festgelegten Schwellwert ($V_{TR}$) besitzt; wobei die erste Speicherzelle (22) eine Lesevorspannung ($V_{CC}$) zwischen dem ersten Anschluss und dem Steueranschluss empfängt; und wobei die zweite Speicherzelle (21) zwischen dem ersten Anschluss und dem Steueranschluss eine zweite Vorspannung ($V_{GS}$) empfängt, welche niedriger als die Lesevorspannung ist.

8. Schaltung nach Anspruch 7, **gekennzeichnet durch**: Eine Lesevorspannungsleitung (15), welche direkt mit dem Steueranschluss der ersten Speicherzelle (22) verbunden ist; und einen Schiebetransistor (29), welcher zwischen der Lesevorspannungsleitung (15) und dem Steueranschluss der zweiten Speicherzelle (21) angeordnet ist.

9. Schaltung nach Anspruch 6, **dadurch gekennzeichnet, dass** die ersten und zweiten Speicherelemente jeweils eine erste und eine zweite Speicherzelle (22, 21) aufweisen, wobei jede einen ersten Anschluss und einen Steueranschluss besitzt; wobei die erste Speicherzelle (22) eine Schwellwertspannung gleich dem vorher festgelegten Schwellwert ($V_{TR}$) besitzt; wobei die zweite Speicherzelle (21) eine Schwellwertspannung gleich dem Triggerwert ($V_S$) besitzt; und wobei die erste und zweite Speicherzelle eine gleiche Lesevorspannung ($V_{CC}$) zwischen dem jeweiligen ersten Anschluss und dem jeweiligen Steueranschluss empfängt.

10. Schaltung nach Anspruch 9, **gekennzeichnet durch** ein Referenzspeicherfeld (53); und **dadurch**, dass die Speicherzellen (22, 21) einen Teil des Referenzspeicherfeldes bilden.

11. Schaltung nach einem der Ansprüche der vorausgehenden Ansprüche 5 bis 10, **gekennzeichnet durch**: eine erste Stromspiegelschaltung, welche wiederum einen ersten (35), einen zweiten (36) und einen dritten (37) Lasttransistor aufweist, wobei der erste Lasttransistor (35) diodenangeschlossen ist und zwischen dem zweiten Speicherelement (21) und einer Referenzpotenzialleitung (15) angeordnet ist, wobei der zweite Lasttransistor (36) zwischen dem ersten Speicherelement (22) und der Referenzpotenzialleitung angeordnet ist, wobei der dritte Lasttransistor (37) zwischen einem Ausgangselement (48, 51) und der Referenzpotenzialleitung angeordnet ist, wobei der erste und zweite Lasttransistor (35, 36) ein erstes Dimensionsverhältnis (W/L = K) besitzen und der dritte Lasttransistor (37) ein zweites Dimensionsverhältnis (W/L = N*K) größer als das erste Dimensionsverhältnis besitzt; und eine zweite Stromspiegelschaltung, welche wiederum einen vierten (40) und einen fünften (44) Lasttransistor aufweist, wobei der vierte Lasttransistor (40) diodenangeschlossen ist und zwischen dem ersten Speicherelement (22) und der Referenzpotenzialleitung (15) angeordnet ist, wobei der fünfte Lasttransistor (44) zwischen dem Ausgangselement (48, 51) und der Referenzpotenzialleitung angeordnet ist, und wobei der vierte und fünfte Lasttransistor (40, 44) ein drittes Dimensionsverhältnis (W/L = K) besitzt.

**12.** Schaltung nach Anspruch 11, **dadurch gekennzeichnet, dass** das Ausgangselement (48, 51) eine dritte Stromspiegelschaltung aufweist, welche einen diodenangeschlossenen ersten Ausgangstransistor (48) beinhaltet, welcher mit den dritten und fünften Lasttransistoren (37, 44) verbunden ist und wenigstens einen zweiten Ausgangstransistor (51) beinhaltet, für die Verbindung zu einem Referenzzweig (3) einer Leseschaltung (1); wobei der erste und zweite Ausgangstransistor ein viertes Dimensionsverhältnis (W/L = K1) besitzt.

**13.** Schaltung nach Anspruch 12, **dadurch gekennzeichnet, dass** der erste und zweite Ausgangstransistor (48, 51) native NMOS-Transistoren sind.

## Revendications

**1.** Procédé de production d'un signal de référence de lecture pour une mémoire non volatile comprenant des cellules de mémoire (4) avec un courant de cellule ($I_{TC}$, $I_{TW}$) présentant une certaine pente de courbe caractéristique du courant de cellule par rapport à la tension d'alimentation ; **caractérisé par** l'étape de production d'un courant de référence ($I_{R1}$) avec une courbe caractéristique du courant de référence par rapport à la tension d'alimentation présentant une première partie s'étendant entre une valeur de tension de seuil prédéterminée ($V_{TR}$) et une valeur de tension de déclenchement ($V_S$) supérieure à ladite valeur de tension de seuil ($V_{TR}$) et ayant une pente égale à ladite pente de courbe caractéristique de cellule, et une seconde partie s'étendant à partir de ladite valeur de déclenchement vers des valeurs de tension d'alimentation supérieures et ayant une pente plus raide que ladite pente de courbe caractéristique de cellule.

**2.** Procédé selon la revendication 1, **caractérisé en ce que** ladite valeur de seuil prédéterminée ($V_{TR}$) dudit signal de référence ($I_{R1}$) est inférieure à une valeur de seuil maximale admissible ($V_{TC}$) pour une cellule effacée ; et ladite valeur de déclenchement ($V_S$) est entre ladite valeur de seuil maximale admissible pour une cellule effacée et une valeur de seuil minimale admissible ($V_{TW}$ - $V_B$) pour une cellule écrite.

**3.** Procédé selon la revendication 1 ou 2, **caractérisé en ce que** ladite étape de production d'un signal de référence comprend les étapes consistant à :

- produire un premier signal ($I_R$) ayant une tension de seuil égale à ladite valeur de seuil prédéterminée ($V_{TR}$), et une pente égale à ladite pente de courbe caractéristique de cellule ;
- produire un deuxième signal ($I_S$) ayant une tension de seuil égale à ladite valeur de déclenchement ($V_S$), et une pente égale à ladite pente de courbe caractéristique de cellule ;

- produire un troisième signal ($I_D$) égal à la différence entre lesdits premier et deuxième signaux ;
- produire un quatrième signal ($I_{SN}$) ayant une tension de seuil égale à ladite valeur de déclenchement, et une pente plus raide que ladite pente de courbe caractéristique de cellule ; et
- ajouter lesdits troisième et quatrième signaux.

**4.** Procédé selon l'une quelconque des revendications précédentes, **caractérisé en ce que** ladite pente de ladite seconde partie de ladite courbe caractéristique de référence ($I_{R1}$) est égale à un multiple de ladite pente de courbe caractéristique de cellule.

**5.** Dispositif de mémoire comprenant des cellules de mémoire non volatiles (4) et un circuit pour produire un signal de référence de lecture pour lesdites cellules de mémoire non volatiles (4), lesdites cellules de mémoire (4) ayant un courant de cellule ($I_{TC}$, $I_{TW}$) présentant une certaine pente de courbe caractéristique du courant de cellule par rapport à la tension d'alimentation ; **caractérisé par** des moyens de production (20) pour produire un courant de référence ($I_{R1}$) avec une courbe caractéristique du courant de référence par rapport à la tension d'alimentation comprenant une première partie s'étendant entre une valeur de tension de seuil prédéterminée ($V_{TR}$) et une valeur de tension de déclenchement ($V_S$) supérieure à ladite valeur de tension de seuil ($V_{TR}$) et ayant une pente égale à ladite pente de courbe caractéristique de cellule, et une seconde partie s'étendant à partir de ladite valeur de déclenchement vers des valeurs de tension d'alimentation supérieures et ayant une pente plus raide que ladite pente de courbe caractéristique de cellule.

**6.** Circuit selon la revendication 5, **caractérisé en ce que** lesdits moyens de production (20) comprennent un premier élément de mémoire (22) pour produire un premier signal ($I_R$) ayant une tension de seuil égale à ladite valeur de seuil prédéterminée ($V_{TR}$) et une pente égale à ladite pente de courbe caractéristique de cellule ; un second élément de mémoire (21) pour produire un deuxième signal ($I_S$) ayant une tension de seuil égale à ladite valeur de déclenchement ($V_S$) et une pente égale à ladite pente de courbe caractéristique de cellule ; un élément de soustraction (38) recevant lesdits premier et deuxième signaux pour produire un troisième signal ($I_D$) égal à la différence entre lesdits premier et deuxième signaux ; un élément de multiplication (40, 44) recevant ledit deuxième signal pour produire un quatrième signal ($I_{SN}$) ayant une tension de seuil égale à ladite valeur de déclenchement et une pente plus raide que ladite pente de courbe caractéristique de cellule ; et un élément d'addition (45) recevant lesdits troisième et quatrième signaux pour produire ledit signal de référence ($I_{R1}$).

**7.** Circuit selon la revendication 6, **caractérisé en ce que** lesdits premier et second éléments de mémoire comprennent respectivement une première et une seconde cellule de mémoire (22, 21), chacune ayant une première borne, une borne de commande, et une tension de seuil égale à ladite valeur de seuil prédéterminée ($V_{TR}$) ; ladite première cellule de mémoire (22) recevant une tension de polarisation de lecture ($V_{CC}$) entre ladite première borne et ladite borne de commande ; et ladite seconde cellule de mémoire (21) recevant, entre ladite première borne et ladite borne de commande, une seconde tension de polarisation ($V_{GS}$) inférieure à ladite tension de polarisation de lecture.

**8.** Circuit selon la revendication 7, **caractérisé par** une ligne de polarisation de lecture (15) reliée directement à ladite borne de commande de ladite première cellule de mémoire (22) ; et un transistor de décalage (29) interposé entre ladite ligne de polarisation de lecture (15) et ladite borne de commande de ladite seconde cellule de mémoire (21).

**9.** Circuit selon la revendication 6, **caractérisé en ce que** lesdits premier et second éléments de mémoire comprennent respectivement une première et une seconde cellule de mémoire (22, 21), chacune ayant une première borne et une borne de commande ; ladite première cellule de mémoire (22) ayant une tension de seuil égale à ladite valeur de seuil prédéterminée ($V_{TR}$) ; ladite seconde cellule de mémoire (21) ayant une tension de seuil égale à ladite valeur de déclenchement ($V_S$) ; et lesdites première et seconde cellules de mémoire recevant une tension de polarisation de lecture égale ($V_{CC}$) entre la première borne respective et la borne de commande respective.

**10.** Circuit selon la revendication 9, **caractérisé par** un groupement de mémoires de référence (53) ; et en ce que lesdites cellules de mémoire (22, 21) forment une partie dudit groupement de mémoires de référence.

**11.** Circuit selon l'une quelconque des revendications précédentes 5 à 10, **caractérisé par** un premier circuit miroir de courant comprenant à son tour un premier (35), un deuxième (36) et un troisième (37) transistor de charge, ledit premier transistor de charge (35) étant monté en diode et interposé entre ledit second élément de mémoire (21) et une ligne de potentiel de référence (15), ledit deuxième transistor de charge (36) étant interposé entre ledit premier élément de mémoire (22) et ladite ligne de potentiel de référence, ledit troisième transistor de charge (37) étant interposé entre un élément de sortie (48, 51) et ladite ligne de potentiel de référence, lesdits premier et deuxième transistors de charge (35, 36) ayant un premier rapport dimensionnel ($W / L = K$), et ledit troisième transistor de charge (37) ayant un deuxième rapport dimensionnel ($W / L = N \times K$) supérieur audit premier rapport dimensionnel ; et un second circuit miroir de courant comprenant à son tour un quatrième (40) et un cinquième (44) transistor de charge, ledit quatrième transistor de charge (40) étant monté en diode et interposé entre ledit premier élément de mémoire (22) et ladite ligne de potentiel de référence (15), ledit cinquième transistor de charge (44) étant interposé entre ledit élément de sortie (48, 51) et ladite ligne de potentiel de référence, et lesdits quatrième et cinquième transistors de charge (40, 44) ayant un troisième rapport dimensionnel ($W / L = K$).

**12.** Circuit selon la revendication 11, **caractérisé en ce que** ledit élément de sortie (48, 51) comprend un troisième circuit miroir de courant comprenant un premier transistor de sortie monté en diode (48) relié auxdits troisième et cinquième transistors de charge (37, 44), et au moins un deuxième transistor de sortie (51) pour connexion à une branche de référence (3) d'un circuit de lecture (1) ; lesdits premier et deuxième transistors de sortie ayant un quatrième rapport dimensionnel ($W / L = K1$).

**13.** Circuit selon la revendication 12, **caractérisé en ce que** lesdits premier et deuxième transistors de sortie (48, 51) sont des transistors NMOS natifs.

Fig.1

Fig.6

Fig.2

Fig.3

Fig.4a

Fig.4b

Fig.4c

Fig. 5

Fig.7

Fig.8

Fig. 9

EP 0 814 482 B1